# EUROPEAN PATENT SPECIFICATION

(11) **EP 0 684 647 B1**
(45) Date of publication and mention of the grant of the patent: **10.10.2001**
(21) Application number: 95104496.5
(22) Date of filing: 27.03.1995
(51) Int. Cl.: H01L 23/535, H01L 21/768, H01L 23/522, H01F 5/00

(54) **Method of manufacturing electronic parts having airbridge interconnection**
Verfahren zur Herstellung elektronischer Teile mit einer Luftbrückenverbindung
Procédé pour fabriquer des pièces électroniques ayant une connection en forme de pont

(30) Priority: 25.05.1994 JP 11137694
(43) Date of publication of application: 29.11.1995
(73) Proprietor: MURATA MANUFACTURING CO., LTD., Nagaokakyo-shi Kyoto-fu 226 (JP)
(72) Inventor: Nakagawara, Osamu, c/o Murata Manuf. Co., Ltd., Nagaokakyo-shi, Kyoto-fu (JP); Kobayashi, Masato, c/o Murata Manuf. Co., Ltd., Nagaokakyo-shi, Kyoto-fu (JP); Yoshino, Yukio, c/o Murata Manuf. Co., Ltd., Nagaokakyo-shi, Kyoto-fu (JP)
(74) Representative: Schoppe, Fritz, Dipl.-Ing.

(56) References cited:
- EP-A- 0 309 805
- EP-A- 0 501 407
- JP-A- 4 290 212
- US-A- 4 308 090

## Description

The present invention relates to a method of manufacturing an electronic part having a flat air-bridge interconnection.

A conventional electronic part having an air-bridge interconnection has a structure in which an air-bridge interconnection body 14b has recessed shoulder portions 14c caused by the manufacturing method thereof at upper portions of posts 14a, as shown in Fig. 11.

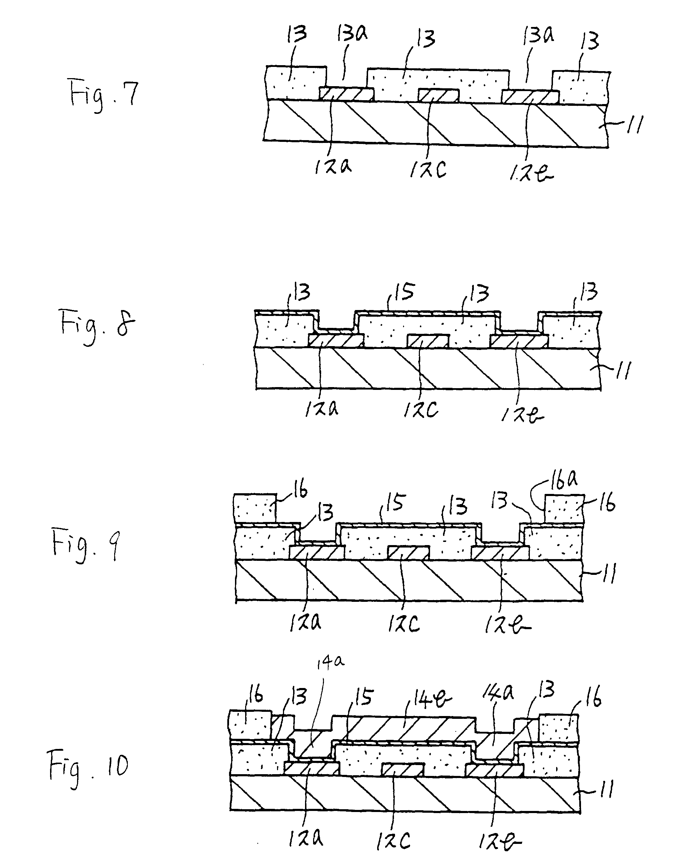

The method of manufacturing such electronic parts having a conventional air-bridge interconnection will be described below with reference to Figs. 7 to 11.

As shown in Fig. 7, post base electrodes 12a and 12b and a lower interconnection 12c bridged between the post base electrodes 12a and 12b are formed on a substrate 11. Next, a lower resist 13 is formed on the substrate 11 in such a manner that openings 13a are formed on the post base electrodes 12a and 12b and that the lower interconnection 12c is covered with the lower resist 13.

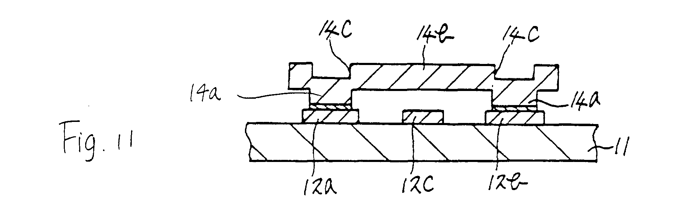

Thereafter, a power supply film 15 for plating is formed on the lower resist 13 and in the openings 13a of the post base electrodes 12a and 12b, as shown in Fig. 8.

As shown in Fig. 9, an upper resist 16 is formed in such a manner that an opening 16a corresponding to a predetermined length of a bridge interconnection body is formed on the power supplying film 15 for plating which is formed on both the post base electrodes 12a and 12b and the lower interconnection 12c.

Subsequently, a metal film constituting posts 14a of an air-bridge interconnection and a metal film constituting a body 14b thereof are formed at the same time, as shown in Fig. 10. Thereafter, the lower resist 13, the portion of the power supplying film 15 formed on the lower resist 13 and the upper resist 16 are removed, whereby an electronic part having an air-bridge interconnection, shown in Fig. 11, is manufactured.

However, since the conventional electronic part having an air-bridge interconnection, shown in Fig. 11, is manufactured by providing the metal film constituting the posts 14a of the air-bridge interconnection and the metal film constituting the body 14b of the air-bridge interconnection at the same time, the shoulder portions 14c are formed in the air-bridge interconnection body 14b above the posts 14a. The shoulder portions 14c generate variations in the thickness of the interconnection and cause conductor loss and deterioration in Q.

US-A-4,308,090 discloses a semiconductor device which has a conductor having an air-bridge interconnection which comprises an air-bridge interconnection body on a post base electrode, wherein said air-bridge interconnection body is formed on a post on said post base electrode and the thickness of said air-bridge interconnection body is constant along its length. The width of the air-bridge interconnection body is not constant along its length.

JP-A-4290212 discloses a semiconductor device which has a spiral inductor having an air-bridge interconnection which comprises an air-bridge interconnection body on a post, wherein said air-bridge interconnection body is formed on a post, and the width of said air-bridge interconnection body is constant along its length. The thickness of the spiral inductor is not constant along its length.

It is the object of the present invention to provide a method for manufacturing an electronic part having an air-bridge interconnection in which an air-bridge interconnection body is flat, has low wiring loss, a high Q value, and consumes a less amount of power.

This object is achieved by a method according to claim 1.

Since the method of manufacturing electronic parts having an air-bridge interconnection according to the present invention is characterized by two-stage deposition which includes deposition conducted to form the posts of the air-bridge interconnection with their top surface at the same level as the top surface of the surrounding lower resist, and deposition conducted to form the metal film of the air-bridge interconnection body, the air-bridge interconnection body can be formed flat.
Fig. 1 illustrates a process in the manufacturing processes according to a first embodiment of the present invention in which post base electrodes, a bridged lower interconnection and a lower resist are formed on a substrate;
Fig. 2 illustrates a process in which posts of an air-bridge interconnection are formed;
Fig. 3 illustrates a process in which a power supplying film for plating and an upper resist are formed;
Fig. 4 illustrates a process in which an air-bridge interconnection body is formed;
Fig. 5 illustrates a process in which the lower resist, the power supplying film for plating and the upper resist are removed;
Fig. 6 is a perspective view of a spiral inductor manufactured by the manufacturing method according to the present invention;
Fig. 7 illustrates a process in conventional manufacturing processes in which post base electrodes, a bridged lower interconnection and a lower resist are formed on a substrate;
Fig. 8 illustrates a process in which a power supplying film for plating is formed;
Fig. 9 illustrates a process in which an upper resist is formed;
Fig. 10 illustrates a process in which posts and a body of an air-bridge interconnection are formed at the same time;
Fig. 11 illustrates a process in which the lower resist, the power supplying film for plating and the upper resist are removed.

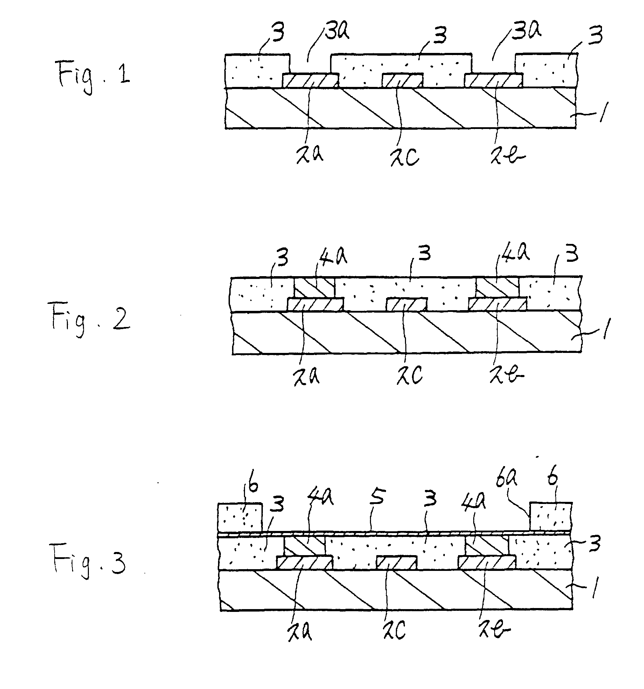

A first embodiment of the manufacturing method according to the present invention will be described with reference to Figs. 1 through 5.

As shown in Fig. 1, a 5 µm-thick Au layer is formed on a ceramic substrate 1 to form post base electrodes 2a and 2b for an air-bridge interconnection and a lower interconnection 2c air-bridged between the post base electrodes 2a and 2b. Next, a lower resist 3 is formed on the substrate 1 in such a manner that openings 3a are formed on the post base electrodes 2a and 2b and that the lower interconnection 2c is covered with the lower resist 3.

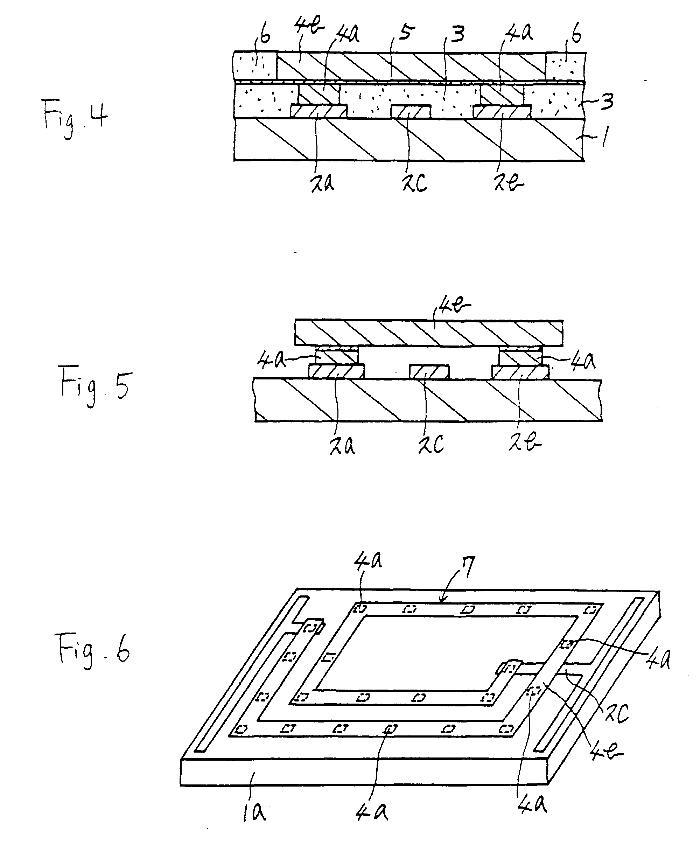

Thereafter, an Au layer is formed in the openings 3a on the post base electrodes 2a and 2b by electrolytic plating in such a manner that it is level with the lower resist 3 to form posts 4a of an air-bridge interconnection, as shown in Fig. 2. At that time, electrolytic plating is conducted for 30 minutes under the conditions that the current value is 3 mA/cm² and that the temperature of a plating solution is 65 °C.

Subsequently, a 50 nm-thick Au layer is formed on both the lower resist 3 and the posts 4a as a power supplying film 5 for plating by electron beam deposition, as shown in Fig. 3. Electron beam deposition is conducted in a planetary system at a deposition rate of 3 nm/sec. The substrate is not heated with the heat resistance of the resist taken into consideration. Next, an upper resist 6, having an opening 6a corresponding to the predetermined length of the bridge interconnection body, is formed to a thickness of 7 µm on the power supplying film 5 for plating by the photolithographic process.

As shown in Fig. 4, a 5 µm-thick Au layer is formed in the opening 6a as an air-bridge interconnection body 4b by electrolytic plating. This electrolytic plating is conducted under the same conditions as those of the electrolytic plating conducted to form the posts 4a shown in Fig.2. Thereafter, the lower resist 3, the portion of the power supplying film 5 formed on the lower resist 3 and the upper resist 6 are removed, whereby an air-bridge interconnection, shown in Fig. 5, is completed.

The present inventors manufactured a spiral inductor 7 having about one and half turns, such as that shown in Fig. 6, by using the manufacturing method according to the first embodiment of the present invention. The size of a GaAs substrate 1a was 1.6 x 3.2 x 0.6 mm. The width and thickness of the metallized layer were 100 µm and 5 µm, respectively. The height of the post was 5 µm, and the inductance was 10 nH.

For comparison, the present inventors manufactured a spiral inductor, such as that shown in Fig. 6, by a conventional manufacturing method, and measured the Q value of both the product according to the present invention and the conventional example at a frequency of 500 MHz. The results of the measurements are shown in Table 1. In the spiral inductor 7 shown in Fig. 6, the lower interconnection 2c intersects the air-bridge interconnection body 4b (the upper interconnection) at a single point, and the entire air-bridge interconnection (the upper interconnection) 4b is floating from the substrate 1a through the plurality of posts 4a. In this embodiment, since there is no variation in the thickness of the interconnection, generated by the recesses of the shoulders, above the posts 4a, as compared with the conventional interconnection, conductor loss is reduced and Q is improved.

**Table 1**

| | Q value |
|---|---|
| The product according to the present invention | 30 |
| Conventional product | 22 |

It is clear from the above table that the Q value of the product according to the present invention is about 36 % higher than that of the conventional product.

A second embodiment of the manufacturing method according to the present invention will be described below.

In the second embodiment, the posts 4a and the air-bridge interconnection body 4b are formed in the processes shown in Figs. 2 and 4, respectively, not by electrolytic plating employed in the first embodiment but by electroless copper plating. Electroless copper plating is conducted using an electroless copper plating solution shown in Table 2 under the conditions shown in Table 2.

**Table 2**

| | | |
|---|---|---|
| Composition | Copper sulfate | 9 g/liter |
| | EDTA | 30 g/liter |
| | Formalin | 4 g/liter |
| | Sodium hydroxide | 4 g/liter |
| | pH | 12 |
| | Stabilizer | little |
| | Surface active agent | little |
| Operation conditions | Temperature | 70 °C |
| | Deposition speed | 2 µm/hr |

Because of the use of electroless copper plating, the fourth manufacturing process of the first embodiment in which the power supplying film for plating is formed is not necessary. Other processes are the same as those of the first embodiment.

A third embodiment of the manufacturing method according to the present invention will be described below.

In the third embodiment, the power supplying film 5 for plating described in connection with Fig. 3 is formed not by electron beam deposition employed in the first embodiment but by sputtering. Sputtering is conducted under the following conditions. Other processes are the same as those of the first embodiment.

**Table 3**

| | |
|---|---|
| The used apparatus | RF magnetron sputter |
| Target | Au |
| Power | 50 W |
| Film forming rate | 0.2 nm/sec |
| Set film thickness | 50 nm |

As will be understood from the foregoing description, the electronic part having an air-bridge interconnection according to the present invention is characterized in that an air-bridge interconnection body formed on the posts of an air-bridge interconnection is flat. Thus, there is no air-bridge interconnection loss, Q is high, and power consumption is reduced.

Further, the method of manufacturing electronic parts having an air-bridge interconnection according to the present invention is characterized by two-stage deposition which includes deposition conducted to form the posts of the air-bridge interconnection with their top surface at the same level as the top surface of the surrounding lower resist, and deposition conducted to form the metal film of the air-bridge interconnection body. Thus, the air-bridge interconnection body can be formed flat.

## Claims

1. A method of manufacturing an electronic part (7), comprising the steps of
(1) forming, on a substrate (1), post base electrodes (2a,2b) for an air-bridge interconnection,
(2) forming, on said substrate (1), a lower resist (3) having post openings (3a) on said post base electrodes (2a,2b),
(3) providing a post of a metal film (4a) in said post openings (3a) on said post base electrodes (2a,2b) by electrolytic deposition in such a manner that the upper surface of said post of said metal film (4a) is level with the upper surface of said lower resist (3),
(4) forming, on said resulting structure, an upper resist (6) having a body opening (6a) corresponding to the length of an air-bridge interconnection body (4b), and
(5) forming a metal film constituting said air-bridge interconnection body (4b) in said body opening (6a), and
6) removing said lower resist (3) and said upper resist (6).

2. A method according to Claim 1, **characterized in that**
the forming step of metal film constituting said air-bridge interconnection body (4b) is carried out by electroless plating.

3. A method according to Claim 1, **characterized in that**
said method further comprises the steps of forming a power supplying film for plating (5) on both said post of metal film (4a) and said lower resist (3) after the post providing step,
the forming step of metal film constituting said air-bridge interconnection body (4b) is carried out by electrolytic plating, and
said power supplying film for plating (5) on said lower resist (3) is removed with said lower resist (3) and said upper resist (6).

4. A method according to Claim 3, **characterized in that**
said power supplying film for plating (5) is formed by electron beam deposition.

5. A method according to Claim 3, **characterized in that**
said power supplying film for plating (5) is formed by sputtering.

## Patentansprüche

1. Ein Verfahren zum Herstellen eines Elektronikbauteils (7) mit folgenden Schritten:
(1) Bilden auf einem Substrat (1) von Pfostenbasiselektroden (2a, 2b) für eine Luftbrückenverbindung,
(2) Bilden auf dem Substrat (1) eines unteren Resists (3), der Pfostenöffnungen (3a) auf den Pfostenbasiselektroden (2a, 2b) aufweist,
(3) Vorsehen eines Pfostens eines Metallfilms (4a) in den Pfostenöffnungen (3a) auf den Pfostenbasiselektroden (2a, 2b) durch elektrolytisches Aufbringen auf eine solche Art und Weise, daß die obere Oberfläche des Pfostens eines Metallfilms (4a) in einer Ebene mit der oberen Oberfläche des unteren Resists (3) liegt,
(4) Bilden auf der resultierenden Struktur eines oberen Resists (6), der eine Körperöffnung (6a) aufweist, die der Länge eines Luftbrückenverbindungskörpers (4b) entspricht, und
(5) Bilden eines Metallfilms, der den Luftbrückenverbindungskörper (4b) bildet, in der Körperöffnung (6a), und
(6) Entfernen des unteren Resists (3) und des oberen Resists (6).

2. Ein Verfahren gemäß Anspruch 1, **dadurch gekennzeichnet, daß** der Schritt des Bildens des Metallfilms, der den Luftbrückenverbindungskörper (4b) bildet, durch ein autokatalytische Plattieren durchgeführt wird.

3. Ein Verfahren gemäß Anspruch 1, **dadurch gekennzeichnet, daß** das Verfahren ferner die Schritte des Bildens eines Leistungsversorgungsfilms zum Plattieren (5) auf sowohl dem Pfosten eines Metallfilms (4a) als auch dem unteren Resist (3) nach dem Schritt des Vorsehens des Pfostens aufweist,
wobei der Schritt des Bildens des Metallfilms, der den Luftbrückenverbindungskörper (4b) bildet, durch autokatalytisches Plattieren durchgeführt wird, und
wobei der Leistungsversorgungsfilm zum Plattieren (5) auf dem unteren Resist (3) mit dem unteren Resist (3) und dem oberen Resist (6) entfernt wird.

4. Ein Verfahren gemäß Anspruch 3, **dadurch gekennzeichnet, daß** der Leistungsversorgungsfilm zum Plattieren (5) durch ein Elektronenstrahlaufbringen gebildet ist.

5. Ein Verfahren gemäß Anspruch 3, **dadurch gekennzeichnet, daß** der Leistungsversorgungsfilm zum Plattieren (5) durch Sputtern gebildet ist.

## Revendications

1. Procédé pour fabriquer une pièce électronique, comprenant les étapes consistant à :
(1) former sur un substrat (1) des électrodes de base de montant (2a, 2b) pour une connexion en forme de pont,
(2) former sur ledit substrat (1) un résiste inférieur (3) présentant des ouvertures de montant (3a) sur lesdites électrodes de base de montant (2a, 2b),
(3) créer un montant de film métallique (4a) dans lesdites ouvertures de montant (3a) sur lesdites électrodes de base de montant (2a, 2b), par dépôt électrolytique, de telle manière que la face supérieure desdits montants dudit film métallique (4a) soit à fleur avec la surface supérieure dudit résiste inférieur (3),
(4) former sur ladite structure qui en résulte un résiste supérieur (6) présentant une ouverture de corps (6a) correspondant à la longueur d'un corps de connexion en forme de pont (4b), et
(5) former un film métallique constituant ledit corps de connexion en forme de pont (4b) dans ladite ouverture de corps (6a), et
(6) éliminer ledit résiste inférieur (3) et ledit résiste supérieur (6).

2. Procédé suivant la revendication 1, **caractérisé par** le fait que l'étape de formation du film métallique constituant ledit corps de connexion en forme de pont (4b) est réalisée par revêtement non-électrolytique.

3. Procédé suivant la revendication 1, **caractérisé par** le fait que
ledit procédé comprend, par ailleurs, les étapes consistant à former un film d'alimentation de courant destiné au revêtement (5) sur tant ledit montant de film métallique (4a) que ledit résiste inférieur (3) après l'étape de création des montants,
l'étape de formation du film métallique constituant ledit corps de connexion en forme de pont (4b) est réalisée par dépôt électrolytique, et
ledit film d'alimentation de courant destiné au revêtement (5) sur ledit résiste inférieur (3) est éliminé avec ledit résiste inférieur (3) et ledit résiste supérieur (6).

4. Procédé suivant la revendication 3, **caractérisé par** le fait que ledit film d'alimentation de courant destiné au revêtement (5) est formé par dépôt par faisceau électronique.

5. Procédé suivant la revendication 3, **caractérisé par** le fait que ledit film d'alimentation de courant destiné au revêtement (5) est formé par dépôt par pulvérisation.
